(19) Europäisches Patentamt
European Patent Office
Office européen des brevets

(11) **EP 2 689 466 B1**

(12) **EUROPÄISCHE PATENTSCHRIFT**

(45) Veröffentlichungstag und Bekanntmachung des Hinweises auf die Patenterteilung:
**04.07.2018   Patentblatt 2018/27**

(51) Int Cl.:
*H01L 31/04* (2014.01)          *H02J 3/38* (2006.01)
*G01R 21/133* (2006.01)          *H02S 50/10* (2014.01)

(21) Anmeldenummer: **12722089.5**

(22) Anmeldetag: **25.04.2012**

(86) Internationale Anmeldenummer:
**PCT/EP2012/057568**

(87) Internationale Veröffentlichungsnummer:
**WO 2012/146618 (01.11.2012 Gazette 2012/44)**

(54) **VERFAHREN UND VORRICHTUNG ZUR BESTIMMUNG EINER VON EINER PHOTOVOLTAISCHEN ANLAGE ABGEGEBENEN LEISTUNG**

METHOD AND APPARATUS FOR DETERMINING THE OUTPUT POWER OF A PHOTOVOLTAIC SYSTEM

PROCÉDÉ ET APPAREIL POUR DETERMINER LA PUISSANCE FOURNIE PAR UN SYSTÈME PHOTOVOLTAÏQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.04.2011   DE 102011017694**

(43) Veröffentlichungstag der Anmeldung:
**29.01.2014   Patentblatt 2014/05**

(73) Patentinhaber: **Siemens Aktiengesellschaft 80333 München (DE)**

(72) Erfinder:
- **BAMBERGER, Joachim**
  **80999 München (DE)**
- **GROTHMANN, Ralph**
  **80801 München (DE)**
- **HEESCHE, Kai**
  **81539 München (DE)**
- **HOFFMANN, Clemens**
  **34125 Kassel (DE)**
- **METZGER, Michael**
  **85570 Markt Schwaben (DE)**

(56) Entgegenhaltungen:
EP-A2- 2 262 096          JP-A- 2007 184 354
JP-A- 2008 182 017          JP-A- 2010 186 840
US-A1- 2011 084 551

- BEYER H G ET AL: "SHORT RANGE FORECAST OF PV ENERGY PRODUCTION USING SATELLITE IMAGE ANALYSIS", 12TH. E.C. PHOTOVOLTAIC SOLAR ENERGY CONFERENCE. AMSTERDAM, THE NETHERLANDS, APRIL 11 - 15, 1994; [PROCEEDINGS OF THE INTERNATIONAL PHOTOVOLTAIC SOLAR ENERGY CONFERENCE], BEDFORD : H.S. STEPHENS & ASSOCIATES, GB, Bd. CONF. 12, 11. April 1994 (1994-04-11), Seiten 1718-1721, XP001137100, ISBN: 978-0-9521452-4-0
- LORENZ E ET AL: "Irradiance Forecasting for the Power Prediction of Grid-Connected Photovoltaic Systems", IEEE JOURNAL OF SELECTED TOPICS IN APPLIED EARTH OBSERVATIONS AND REMOTE SENSING, IEEE, USA, Bd. 2, Nr. 1, 1. März 2009 (2009-03-01), Seiten 2-10, XP011256562, ISSN: 1939-1404
- HOFF T E ET AL: "Quantifying PV power Output Variability", SOLAR ENERGY, PERGAMON PRESS. OXFORD, GB, Bd. 84, Nr. 10, 1. Oktober 2010 (2010-10-01), Seiten 1782-1793, XP027248955, ISSN: 0038-092X [gefunden am 2010-08-11]

EP 2 689 466 B1

- MELLIT A ET AL: "Artificial intelligence techniques for photovoltaic applications: A review", PROGRESS IN ENERGY AND COMBUSTION SCIENCE, ELSEVIER SCIENCE PUBLISHERS, AMSTERDAM, NL, Bd. 34, Nr. 5, 1. Oktober 2008 (2008-10-01), Seiten 574-632, XP022931260, ISSN: 0360-1285, DOI: 10.1016/J.PECS.2008.01.001 [gefunden am 2008-03-04]

**Beschreibung**

Die Erfindung betrifft ein Verfahren und eine Vorrichtung zur Bestimmung einer von einer photovoltaischen Anlage abgegebenen Leistung.

Die zunehmende Bedeutung von erneuerbaren Energien in Energienetzen stellt neue Anforderungen an die Vorhersage von benötigten und verfügbaren Einspeiseleistungen, um so das Netz bestmöglich steuern zu können. Diese Herausforderung spiegelt sich in den Konzepten sogenannter "Smartgrids" wider, die auch eine dezentrale Steuerung der Energieflüsse zulassen.

Aus [Zimmermann H. G., Neuneier R., Grothmann R.: Modeling of Dynamical Systems by Error Correction Neural Networks, in: Modeling and Forecasting Financial Data, Techniques of Nonlinear Dynamics, Eds. Soofi, A. and Cao, L., Kluwer Academic Publishers, 2002, pp. 237-263] ist ein sogenanntes fehlerkorrigierendes Neuronales Netz (Error Correction Neural Network, ECNN) bekannt.

Um eine Steuerung von Lastflüssen in einem untergeordneten Netzabschnitt des Energienetzes ausgleichen zu können ohne dabei Energie aus einem übergeordneten Netzabschnitt in Anspruch nehmen zu müssen, ist es nötig, die voraussichtlichen Einspeiseleistungen vorab zu kennen. So kann die Leistungsbilanz und/oder die Betriebsmittelbelastung über steuerbare Verbraucher, Energiespeicher oder Energieerzeuger (z.B. Kraft-Wärme-Kopplungsanlagen (KWK-Anlagen)) ausgeglichen werden, allerdings ist dafür ein gewisser zeitlicher Vorlauf nötig, um deren Dynamik (zeitlich verzögertes Ansprechverhalten) berücksichtigen zu können und letztlich sicherzustellen, dass die steuerbaren Verbraucher, Energiespeicher oder Energieerzeuger rechtzeitig funktionsbereit sind.

Dies ist besonders bei den erwähnten erneuerbaren Energien problematisch, weil die bereitgestellte Leistung kurzfristig stark variieren kann.

[JP 2010-186840 A] betrifft ein photovoltaische Anlage, bei welcher eine Vorhersage von zukünftig erzeugter elektrischer Leistung durch Erfassung von Wolken und anhand von Informationen bezüglich der von den Solar-Paneelen aktuell erzeugten elektrischen Leistung ermöglicht wird.

[JP 2008-182017 A] betrifft ein Kontrollverfahren für photovoltaische Anlagen zur Erzeugung von elektrischer Leistung, wobei im Überschuss erzeugte elektrische Leistung eingespeist und bei einem Mangel an erzeugter elektrischer Leistung die fehlende Leistung mit Hilfe einer Backup-Solarzellenanlage bereitgestellt wird.

[JP 2007-184354 A] betrifft eine photovoltaische Anlage zur Erzeugung elektrischer Leistung, bei der mit Hilfe einer 360°-Kamera der Himmel über der installierten Anlage erfasst sowie daraus durch einen Bild-Prozessor die Verteilung und Bewegung von Wolken ermittelt wird. Mit Hilfe der ermittelten Informationen wird die zukünftige Wolkenverteilung an einem bestimmten Ort vorherbestimmt und basierend darauf die zukünftig erzeugte elektrische Leistung der photovoltaischen Anlage bestimmt.

[EP 2 262 096 A2] betrifft ein Verfahren und eine Vorrichtung zur Abschattungsprognose für eine Photovoltaikanlage, bei der ein Teil des Firmamentes über der Photovoltaikanlage mit Hilfe einer Digitalkamera erfasst und anschließend analysiert wird. Das Ergebnis der Analyse dient dazu, die elektrische Leistung der PV-Anlage bei Bedarf durch Zuschalten eines Ersatzenergielieferanten auf einen Mindestwert aufzustocken oder den Energiebedarf durch Wegschalten von Verbrauchern so zu reduzieren, dass wichtige Verbraucher nicht unter einen Mindestwert an zugelieferter Energie fallen.

[US 2011/0084551 A1] betrifft ein Photovoltaiksystem zur Erzeugung elektrischer Energie welches einen Sensor umfasst, mittels dem zukünftige Änderungen der durch die Anlage bereitgesellten elektrischen Energie ermittelt werden können.

Die Aufgabe der Erfindung besteht darin, die vorstehend genannten Nachteile zu vermeiden und insbesondere eine Lösung anzugeben, die eine effiziente Ansteuerung eines Netzabschnitts ermöglicht, auch wenn dieser Energiequellen aufweist, die auf erneuerbaren Energien basieren.

Diese Aufgabe wird gemäß den Merkmalen der unabhängigen Patentansprüche gelöst. Weiterbildungen der Erfindung ergeben sich auch aus den abhängigen Ansprüchen.

Zur Lösung der Aufgabe wird ein Verfahren zur Bestimmung einer von einer photovoltaischen Anlage abgegebenen Leistung angegeben

- basierend auf mindestens einer Abschattungsinformation von mindestens einer benachbarten photovoltaischen Anlage.

Bei der benachbarten photovoltaischen Anlage kann es sich auch um eine (örtlich) benachbarte Messzone handeln, die Daten über eine Abschattung solarer Strahlung bereitstellt.

Somit kann eine effiziente und kurzfristige Vorhersage einer Abschattung für die photovoltaische Anlage erfolgen, indem die geografische Anordnung zu der mindestens einen anderen photovoltaischen Anlage berücksichtigt wird. Durch die Bestimmung einer Dynamik der Abschattung, z.B. einer Wolkenbewegung, ist es möglich, die Orientierung der Abschattung und die Geschwindigkeit zu prognostizieren. Unter Berücksichtigung der Entfernung zwischen der photovoltaischen Anlage und der benachbarten photovoltaischen Anlage kann die Zeit bis zum Eintreffen der Abschattung ermittelt werden. Entsprechend können - je nach Art und Ausmaß der Abschattung - rechtzeitig steuerbare Verbraucher, Energiespeicher oder Energieerzeuger aktiviert werden.

Dieser Ansatz verfügt über eine hohe Genauigkeit, weil Wettersituationen in hoher zeitlicher Auflösung und Genauigkeit generiert und berücksichtigt werden. Somit ist auch eine Vorhersage der Abschattungen für photovoltaische Anlagen möglich, für die die global verfügbaren Wetterinformationen sowie deren zeitliche Vorhersagedauer zu grob und ungenau sind.

Eine Weiterbildung ist es, dass die Abschattungsinformation eine Information umfasst, die auf einer reduzierten Helligkeit beruht und insbesondere basiert auf einer durch eine Wolkenbewegung begründeten Abschattung.

So beruht die Abschattung beispielsweise auf einer temporären Abschattung solarer Strahlung durch Wolken und andere Wettereffekte.

Eine andere Weiterbildung ist es, dass

- mehrere Abschattungsinformationen von mehreren benachbarten photovoltaischen Anlagen bereitgestellt werden,
- basierend auf den Abschattungsinformationen eine zeitliche und örtliche Vorhersage in Bezug auf eine bevorstehende Abschattung ermittelt wird,
- anhand der bevorstehenden Abschattung die zu erwartende abgegebene Leistung der photovoltaischen Anlage bestimmt wird.

Somit kann anhand der zu erwartenden abgegebenen Leistung der photovoltaischen Anlage frühzeitig festgestellt werden, dass zusätzlich eine andere Energiequelle benötigt wird, um die bevorstehende Abschattung und den damit verbundenen Leistungseinbruch der photovoltaischen Anlage zu kompensieren.

Insbesondere ist es eine Weiterbildung, dass abhängig von der zu erwartenden abgegebene Leistung der photovoltaischen Anlage eine andere Energiequelle aktiviert wird.

Auch ist es eine Weiterbildung, dass die andere Energiequelle mindestens eine der folgenden Energiequellen umfasst:

- einen steuerbaren Verbraucher,
- einen Energiespeicher,
- einen Energieerzeuger.

Ferner ist es eine Weiterbildung, dass die mehreren benachbarten photovoltaischen Anlagen zumindest teilweise die photovoltaische Anlage räumlich umgeben.

So können die benachbarten photovoltaischen Anlagen um die photovoltaische Anlage herum angeordnet sein. Vorzugsweise überlappen sich die photovoltaischen Anlagen nicht.

Im Rahmen einer zusätzlichen Weiterbildung wird basierend auf den Abschattungsinformationen eine zeitliche und örtliche Vorhersage in Bezug auf eine bevorstehende Abschattung anhand eines Vorhersagemodells ermittelt.

Bei dem Vorhersagemodell handelt es sich beispielsweise um ein nicht-lineares Zustandsraummodell zur Identifikation und Prognose eines offenen dynamischen Systems, das von einer internen Dynamik (Anlagencharakteristik) einerseits und von externen Einflussfaktoren (z.B. Wetterlage und Situation der benachbarten Anlagen) andererseits getrieben wird. Das Modell kann in Form eines zeitlich entfalteten rekurrenten Neuronalen Netzes formuliert sein. Die Zustands- und die Ausgabegleichung der offenen Dynamik sind vorzugsweise als parametrisierte Funktionen des Neuronalen Netzes beschrieben. Die Parameter werden durch Optimierungsalgorithmen an die Beobachtungsdaten angepasst, um eine möglichst hohe Prognosegüte zu erzielen. Optional enthält das Neuronale Netz einen Fehlerkorrekturmechanismus, der auf Störungen der Dynamik reagiert und diese zumindest teilweise ausgleicht. Das Neuronale Netz weist u.a. den Vorteil auf, dass nicht-lineare Einflüsse abgebildet werden können.

Eine nächste Weiterbildung besteht darin, dass eine Geschwindigkeit einer Abschattung, insbesondere eines Wolkenzugs, ermittelt wird durch eine Maximierung einer Kreuzkorrelation $R_{ab}$

$$R_{ab} = \frac{1}{T} \cdot \int_{-T/2}^{T/2} P_a(t) \cdot P_b(t + \tau) dt$$

mit

$$\tau = \frac{d_{ab}}{v_{\text{Wolke}}},$$

wobei

a, b        zwei photovoltaische Anlagen,
T            ein betrachtetes Zeitintervall,
P            eine Einspeiseleistung,
$d_{ab}$     einen Abstand zwischen den photovoltaischen Anlagen a und b,
$v_{\text{Wolke}}$   eine geschätzte Geschwindigkeit des Wolkenzugs

bezeichnen.

Eine Ausgestaltung ist es, dass eine Richtung der Abschattung, insbesondere des Wolkenzugs, ermittelt wird anhand eines Vergleichs der Kreuzkorrelationen von räumlich verschieden ausgerichteten photovoltaischen Anlagen.

Dazu werden für die benachbarten PV-Anlagen jeweils paarweise die Kreuzkorrelationen berechnet und diejenigen PV-Anlagen mit der höchsten Korrelation der Änderung der eingespeisten Energiemenge bestimmt. Aus der räumlichen Anordnung der Anlagen und der zeitlichen Verschiebung der Änderungen kann dann eine Bewegungsrichtung und eine Bewegungsgeschwindigkeit des Wolkenzugs berechnet werden.

Eine alternative Ausführungsform besteht darin, dass

- eine Richtung einer großräumigen Luftströmung bestimmt wird,
- eine Varianz der Kreuzkorrelation verschieden weit entfernter photovoltaischer Anlagen bestimmt wird;
- anhand der Richtung der Luftströmung und der Varianz eine Veränderung der Abschattung, insbesondere eine Veränderung einer Form des Wolkenzugs, ermittelt wird.

Zur Bestimmung einer großräumigen Luftströmung werden zunächst gemäß obigem Ansatz die Bewegungsrichtungen und Bewegungsgeschwindigkeiten verschiedener Abschattungen als Bewegungsvektoren berechnet. Aus mehreren dieser Bewegungsvektoren kann dann z.B. durch Mittelwertbildung eine großräumige Bewegung der Abschattungen (und damit der Luftströmung) berechnet werden. Dazu ist es vorteilhaft, die Bewegung einer Abschattung über eine Reihe von PV-Anlagen in Bewegungsrichtung der Abschattung zu beobachten. Da sich die Form einer Abschattung während ihrer Bewegung über die PV-Anlagen deutlich verändern kann, kann z.B. die Varianz der Bewegungsrichtungen und Bewegungsgeschwindigkeiten als Maß für die Veränderung der Wolkenformen herangezogen werden und so in der Vorhersage der künftigen Abschattungen berücksichtigt werden.

Eine nächste Ausgestaltung ist es, dass die zu erwartende abgegebene Leistung der photovoltaischen Anlage bestimmt wird basierend auf der ermittelten Veränderung der Abschattung.

Zur Abschätzung einer absoluten Einspeiseleistung können bekannte Modelle eingesetzt werden, die mittels meteorologischer Informationen und der PV-Anlagenparameter die Einspeiseleistung schätzen, wobei deren Ausgabe mittels der neu gewonnenen Wolkenzugdaten korrigiert werden kann.

Hierbei werden häufig analytische (physikalische) Modelle eingesetzt, die anhand der Anlagencharakteristik, nicht aber der räumlichen Situation bzw. Nachbarschaft kalibriert werden. Die Berücksichtigung externer Einflüsse bleibt hierbei auf wenige lokale Messwerte beschränkt. Zudem ist die Art der Wechselbeziehungen zwischen externen Faktoren und der Einspeiseleistung häufig nur auf lineare Zusammenhänge beschränkt.

Auch ist es eine Ausgestaltung, dass die Leistung der photovoltaischen Anlage bestimmt wird basierend auf einem hybriden Modell, insbesondere auf einem fehlerkorrigierenden Neuronalen Netz.

So kann anhand des fehlerkorrigierenden Neuronalen Netzes (Error Correction Neural Network, ECNN) die Abweichung zwischen dem o.g. Modell nach dem Stand der Technik (z.B. ein analytisches Modell) und der tatsächlichen Einspeiseleistung unter Einbeziehung der Wolkenzuginformation und ggf. anderer (lokal erhobener) Daten, z.B. der Temperatur, korrigiert werden.

Die vorstehend genannte Aufgabe wird auch gelöst durch eine Vorrichtung zur Einstellung einer photovoltaischen Anlage mit einer Verarbeitungseinheit, die derart eingerichtet ist, dass eine von der photovoltaischen Anlage abgegebene Leistung bestimmbar ist basierend auf mindestens einer Abschattungsinformation von mindestens einer benachbarten photovoltaischen Anlage.

Insbesondere wird zur Lösung der Aufgabe auch eine PV-Anlage vorgeschlagen, die eine Verarbeitungseinheit aufweist, anhand derer eine von der photovoltaischen Anlage abgegebene Leistung bestimmbar ist basierend auf mindestens einer Abschattungsinformation von mindestens einer benachbarten photovoltaischen Anlage.

Die Verarbeitungseinheit kann insbesondere eine Prozessoreinheit und/oder eine zumindest teilweise fest verdrahtete oder logische Schaltungsanordnung sein, die beispielsweise derart eingerichtet ist, dass das Verfahren wie hierin beschrieben durchführbar ist. Besagte Verarbeitungseinheit kann jede Art von Prozessor oder Rechner oder Computer mit entsprechend notwendiger Peripherie (Speicher, Input/Output-Schnittstellen, Ein-Ausgabe-Geräte, etc.) sein oder umfassen.

Die vorstehenden Erläuterungen betreffend das Verfahren gelten für die Vorrichtung entsprechend. Die Vorrichtung kann in einer Komponente oder verteilt in mehreren Komponenten ausgeführt sein. Insbesondere kann auch ein Teil der Vorrichtung über eine Netzwerkschnittstelle (z.B. das Internet) angebunden sein.

Eine Weiterbildung besteht darin, dass die Vorrichtung eine photovoltaische Anlage ist.

Auch wird die Aufgabe gelöst durch ein System umfassend mindestens eine der hierin beschriebenen Vorrichtungen oder photovoltaischen Anlagen.

Ausführungsbeispiele der Erfindung werden nachfolgend anhand der Zeichnungen dargestellt und erläutert.

Es zeigen:

Fig.1 ein schematisches Schaubild mit einer PV-Anlage umgeben von mehreren PV-Anlagen (auch bezeichnet als benachbarte PV-Anlagen);

Fig.2 ein Blockdiagramm mit Schritten des Verfahrens zur Bestimmung bzw. Vorhersage einer von einer PV-Anlage abgegeben Leistung.

Die vorgeschlagene Lösung zur Vorhersage der Einspeiseleistung von photovoltaischen Anlagen (PV-Anlagen) zeichnet sich insbesondere dadurch aus, dass die Effekte durch die temporäre Abschattung solarer Strahlung durch Wolken und andere Wettereffekte berücksichtigt werden können.

Hierzu werden Informationen von den räumlich benachbarten PV-Anlagen in einem Vorhersagemodell berücksichtigt. Die Nutzung dieser Informationen kann beispielsweise anhand sogenannter Messzonen erfolgen, wobei eine Messzone mehrere PV-Anlagen aufweist, die eine aktuelle zu betrachtende Anlage räumlich umgeben.

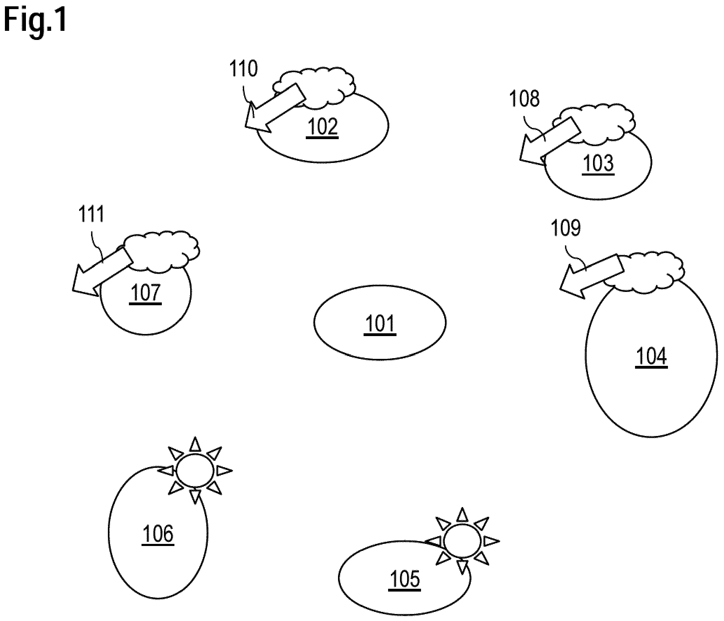

Fig.1 zeigt ein schematisches Schaubild mit einer PV-Anlage 101 und mehreren benachbarten PV-Anlagen 102 bis 107. Jede der PV-Anlagen 101 bis 107 verfügt über eine Messzone, anhand derer eine Abschattung bestimmt werden kann. Bei der Messzone handelt es sich bevorzugt um die Solarmodule: Anhand der Variation der abgegebenen Leistung kann auf die Abschattung rückgeschlossen werden. So kann ein einzelnes Solarmodul oder es kann eine Gruppe von Solarmodulen als Messzone herangezogen werden. Auch ist es möglich, dass mehrere (z.B. kleine) PV-Anlagen zu einer einzelnen Messzone zusammengefasst werden; entsprechend können große PV-Anlagen als einzelne Messzone genutzt werden oder sogar mehrere Messzonen bereitstellen.

In Fig.1 entspricht beispielhaft jede PV-Anlage 101 bis 107 einer Messzone, wobei die PV-Anlagen 102 bis 107 genutzt werden, um eine Abschattung der PV-Anlage 101 zu prognostizieren. Beispielhaft scheint die Sonne (ohne Abschattung durch Wolken) über den PV-Anlagen 105 und 106. Entsprechend ist hier keine Abschattung messbar. Über den PV-Anlagen 102, 103, 104 und 107 befinden sich jeweils Wolken, so dass es zu einer teilweisen Abschattung der solaren Strahlung kommt. Die Abschattung kann anhand der jeweiligen Messzone bestimmt werden. Auch kann ein zeitlicher Verlauf der Abschattung ermittelt werden. Durch den zeitlichen Verlauf der Abschattung kann auf eine Richtung 109 bis 111 der Bewegung der Wolken sowie deren Geschwindigkeit rückgeschlossen werden. Diese Information können die benachbarten PV-Anlagen 102 bis 104 und 107 der PV-Anlage 101 bereitstellen, die aufgrund der Entfernung zu den benachbarten PV-Anlagen 102 bis 104 und 107 prognostizieren kann, wann mit einer Abschattung zu rechnen ist und ggf. wie stark diese Abschattung ausfallen wird.

Der Grad der Bewölkung in den benachbarten Messzonen der PV-Anlagen 102 bis 107 kann dabei ein erster Anhaltspunkt für eine Änderung der Einspeiseleistung sein. Um eine genauere Vorhersage bestimmen zu können, werden eine Richtung eines Wolkenzuges und ein Muster der Wolkenverteilung, d.h. insbesondere eine Form, Länge und Breite einer Wolke sowie deren Veränderung, berücksichtigt.

Zur Bestimmung dieser Faktoren wird vorzugsweise nicht die bodennahe Luftströmung herangezogen (da diese nur bedingt mit der Richtung des Wolkenzuges korreliert ist). Auch ist es eine Option, dass Einflüsse von niedrigen, mittelhohen und hohen Wolken unterschieden werden. Da der Einfluss mittelhoher und hoher Wolken in der Vorhersage durch den Bewölkungsgrad in der vorgeschlagenen Lösung aus den meteorologischen Daten abgeleitet wird, bezieht sich der vorliegenden Ansatz auch auf den Einfluss derjenigen Wolken, die für die kurzfristigen Abschattungseffekte verantwortlich sind und womöglich in den meteorologischen Daten (noch) nicht berücksichtigt sind.

Die hier vorgeschlagene Lösung bestimmt die o.g. Parameter über eine Kreuzkorrelation $R_{ab}$ der verschiedenen PV-Anlagen in den Messzonen. Dabei kann die Kreuzkorrelation $R_{ab}$ einer Einspeiseleistung P zweier PV-Anlagen a und b, die in einem Abstand $d_{ab}$ zueinander angeordnet sind, bestimmt werden gemäß der Beziehung:

$$R_{ab} = \frac{1}{T} \cdot \int_{-T/2}^{T/2} P_a(t) \cdot P_b(t + \tau) dt$$

mit

$$\tau = \frac{d_{ab}}{v_{\text{Wolke}}},$$

wobei T ein betrachtetes Zeitintervall bezeichnet und $v_{\text{wolke}}$ eine (geschätzte) Geschwindigkeit des Wolkenzugs ist.

Die Geschwindigkeit eines Wolkenzugs kann dabei anhand einer Maximierung der Kreuzkorrelationen aus verschiedenen PV-Anlagenpaaren in gleicher räumlicher Ausrichtung bestimmt werden, während die Richtung des Wolkenzugs über den Vergleich der Kreuzkorrelationen von räumlich verschieden ausgerichteten PV-Anlagenpaaren bestimmt werden kann.

Bei der Auswertung der Kreuzkorrelationen verschiedener PV-Anlagenpaare wird vorzugsweise berücksichtigt, dass die Form und Bewegung eines Wolkenzugs von überlagerten Effekten beeinflusst werden kann. Solche überlagerten Effekte können getrennt voneinander ermittelt werden. Zum einen bewegt sich ein Wolkenzug im Rahmen einer weiträumigen Wetterströmung, so dass die Kreuzkorrelation auch von weiter auseinanderliegenden PV-Anlagenpaaren hoch sein sollte. Allerdings führt die Überlagerung von vertikalen Luftströmungen zu einer Veränderung der Form und der optischen Dichte eines Wolkenzugs, so dass die Kreuzkorrelation zwischen weiter entfernten PV-Anlagenpaaren stark abnehmen kann.

Die hier vorgestellte Lösung macht sich insbesondere diesen Effekt zunutze, indem beispielsweise zuerst die Richtung der weiträumigen Luftströmung bestimmt wird und danach die Varianz der Kreuzkorrelation verschieden weit in der Richtung der weiträumigen Luftströmung voneinander entfernter PV-Anlagen bestimmt wird. Aufgrund dieser Daten kann dann die Veränderung des Wolkenzugs bzgl. seiner Form abgeschätzt werden.

Die so ermittelten Daten über Wolkenzüge werden von den Messzonen einer Vorhersagezone bereitgestellt, wobei jede Zone je nach Situation sowohl Messzone als auch Vorhersagezone sein kann.

Somit ist es von Vorteil, die Zonen so auszulegen, dass sie den Netzabschnitten eines Smartgrids entsprechen. In diesem Fall kann ein Auftreten zusätzlicher Effekte durch überlappende Zonen vermieden werden.

Die Vorhersagezone nutzt vorzugsweise die von den Messzonen und den eigenen Messungen ermittelte Richtung der weiträumigen Luftströmung, um diejenigen Messzonen zu identifizieren, die in Strömungsrichtung vor ihr liegen und somit in Bezug auf die Vorhersage relevante Daten bereitstellen können. Da die Bestimmung der Strömungsrichtung mit einer Unsicherheit behaftet ist, kann es vorteilhaft sein, die Daten von weiteren Messzonen gewichtet mit der Abweichung von der geschätzten Luftströmungsrichtung einzubeziehen.

Die Änderung der Einspeiseleistung der Vorhersagezone kann nun auf Basis der geschätzten Bewegung eines Wolkenzugs über die Vorhersagezone bestimmt werden, wobei in einem ersten Ansatz die Veränderung aus der aktuellen Einspeiseleistung und Wolkenabschattung relativ zur zukünftigen Wolkenabschattung geschätzt werden kann.

Zur Abschätzung einer absoluten Einspeiseleistung können bekannte Modelle (z.B. analytische Modelle) eingesetzt werden, die mittels meteorologischer Informationen und der PV-Anlagenparameter die Einspeiseleistung schätzen, wobei deren Ausgabe mittels der neu gewonnenen Wolkenzugdaten korrigiert werden kann.

Beispielsweise kann hierfür ein hybrides Modell eingesetzt werden, bei dem ein sogenanntes fehlerkorrigierendes Neuronales Netz (Error Correction Neural Network, ECNN) die Abweichung zwischen dem o.g. Modell nach dem Stand der Technik und der tatsächlichen Einspeiseleistung unter Einbeziehung der Wolkenzuginformation und ggf. anderer (lokal erhobener) Daten, z.B. der Temperatur, korrigiert.

Die hier vorgeschlagene Lösung ermöglicht somit eine kurzfristige Vorhersage von Abschattungseffekten für PV-Anlagen und bildet so eine Basis für den Ausgleich zwischen der eingespeisten und der benötigten Energiemenge, da für eine kosteneffiziente Balancierung der Lastflüsse einige Betriebsmittel vorab (d.h. rechtzeitig) angesteuert werden müssen. Beispielsweise muss eine KWK-Anlage rechtzeitig gestartet werden, um im Fall der Abschattung der PV-Anlage die ausfallende Energie bereitstellen zu können.

Ein Ziel einer solchen Balancierung besteht darin, den Bezug von Regelleistung aus dem übergeordneten Netzabschnitt zu vermeiden, um so zusätzliche Kosten einzusparen.

Eine Option besteht darin, die von den Messzonen bestimmten Daten an einen zentralen Dienst, z.B. einen meteorologischen Dienst, weiterzuleiten, um dessen Vorhersagen durch zusätzliche lokale Informationen zu verbessern.

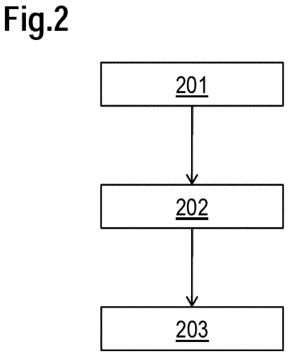

Fig.2 zeigt ein Blockdiagramm mit Schritten des Verfahrens zur Bestimmung bzw. Vorhersage einer von einer PV-Anlage abgegeben Leistung.

In einem Schritt 201 wird eine Abschattungsinformation von mindestens einer benachbarten PV-Anlage, z.B. von mindestens einer Messzone der benachbarten PV-Anlage, bereitgestellt. In einem Schritt 202 wird anhand der Abschattungsinformation eine Vorhersage für eine bevorstehende Abschattung, z.B. betreffend einen Wolkenzug, ermittelt und in einem Schritt 203 wird abhängig von dieser Vorhersage die für die aktuelle PV-Anlage prognostizierte abgegebene Leistung bestimmt. Somit kann entschieden werden, ob (z.B. bei Erreichen eines vorgegebenen Schwellwerts) eine Ersatz-Energiequelle aktiviert werden muss, um eine Leistungseinbuße der aktuellen PV-Anlage zu kompensieren.

## Patentansprüche

1. Verfahren zur Bestimmung einer von einer photovoltaischen Anlage abgegebenen Leistung

   - basierend auf mindestens einer Abschattungsinformation von mindestens einer benachbarten photovoltaischen Anlage,
   - bei dem mehrere Abschattungsinformationen von mehreren benachbarten photovoltaischen Anlagen bereitgestellt werden,
   - bei dem basierend auf den Abschattungsinformationen eine zeitliche und örtliche Vorhersage in Bezug auf eine bevorstehende Abschattung ermittelt wird,
   - bei dem anhand der bevorstehenden Abschattung die zu erwartende abgegebene Leistung der photovoltaischen Anlage bestimmt wird,
   - bei dem eine Geschwindigkeit einer Abschattung, insbesondere eines Wolkenzugs, ermittelt wird durch eine Maximierung einer Kreuzkorrelation $R_{ab}$

$$R_{ab} = \frac{1}{T} \cdot \int_{-T/2}^{T/2} P_a(t) \cdot P_b(t+\tau)\,dt$$

   mit

$$\tau = \frac{d_{ab}}{v_{\text{Wolke}}},$$

   wobei

   a, b zwei photovoltaische Anlagen,
   T ein betrachtetes Zeitintervall,
   P eine Einspeiseleistung,
   $d_{ab}$ einen Abstand zwischen den photovoltaischen Anlagen a und b,
   $v_{\text{Wolke}}$ eine geschätzte Geschwindigkeit des Wolkenzugs

bezeichnen..

2. Verfahren nach Anspruch 1, bei dem die Abschattungsinformation eine Information umfasst, die auf einer reduzierten Helligkeit beruht und insbesondere basiert auf einer durch eine Wolkenbewegung begründeten Abschattung.

3. Verfahren nach einem der vorhergehenden Ansprüche, bei dem abhängig von der zu erwartenden abgegebene Leistung der photovoltaischen Anlage eine andere Energiequelle aktiviert wird.

4. Verfahren nach Anspruch 3, bei dem die andere Energiequelle mindestens eine der folgenden Energiequellen umfasst:

   - einen steuerbaren Verbraucher,
   - einen Energiespeicher,
   - einen Energieerzeuger.

5. Verfahren nach einem der vorhergehenden Ansprüche, bei dem die mehreren benachbarten photovoltaischen Anlagen zumindest teilweise die photovoltaische Anlage räumlich umgeben.

6. Verfahren nach einem der vorhergehenden Ansprüche, bei dem basierend auf den Abschattungsinformationen eine zeitliche und örtliche Vorhersage in Bezug auf eine bevorstehende Abschattung anhand eines Vorhersagemodells ermittelt wird.

7. Verfahren nach einem der vorhergehenden Ansprüche, bei dem eine Richtung der Abschattung, insbesondere des Wolkenzugs, ermittelt wird anhand eines Vergleichs der Kreuzkorrelationen von räumlich verschieden ausgerichteten photovoltaischen. Anlagen.

8. Verfahren nach einem der vorhergehenden Ansprüche, bei dem

   - eine Richtung einer Luftströmung bestimmt wird,
   - eine Varianz der Kreuzkorrelation verschieden weit entfernter photovoltaischer Anlagen bestimmt wird;
   - anhand der Richtung der Luftströmung und der Varianz eine Veränderung der Abschattung, insbesondere eine Veränderung einer Form des Wolkenzugs, ermittelt wird.

9. Verfahren nach Anspruch 8, bei dem die zu erwartende abgegebene Leistung der photovoltaischen Anlage bestimmt wird basierend auf der ermittelten Veränderung der Abschattung.

10. Verfahren nach Anspruch 9, bei dem die Leistung der photovoltaischen Anlage bestimmt wird basierend auf einem hybriden Modell, insbesondere auf einem fehlerkorrigierenden Neuronalen Netz.

11. Vorrichtung zur Einstellung einer photovoltaischen Anlage mit einer Verarbeitungseinheit, die derart eingerichtet ist,

   - dass eine von der photovoltaischen Anlage abgegebene Leistung bestimmbar ist basierend auf mindestens einer Abschattungsinformation von mindestens einer benachbarten photovoltaischen Anlage,
   - dass mehrere Abschattungsinformationen von mehreren benachbarten photovoltaischen Anlagen bereitgestellt werden,
   - dass basierend auf den Abschattungsinformationen eine zeitliche und örtliche Vorhersage in Bezug auf eine bevorstehende Abschattung ermittelt wird,
   - dass anhand der bevorstehenden Abschattung die zu erwartende abgegebene Leistung der photovoltaischen Anlage bestimmt wird,
   - dass eine Geschwindigkeit einer Abschattung, insbesondere eines Wolkenzugs, ermittelt wird durch eine Maximierung einer Kreuzkorrelation $R_{ab}$

$$R_{ab} = \frac{1}{T} \cdot \int_{-T/2}^{T/2} P_a(t) \cdot P_b(t+\tau) dt$$

mit

$$\tau = \frac{d_{ab}}{v_{\text{Wolke}}},$$

wobei

   a, b zwei photovoltaische Anlagen,
   T ein betrachtetes Zeitintervall,
   P eine Einspeiseleistung,
   $d_{ab}$ einen Abstand zwischen den photovoltaischen Anlagen a und b,
   $v_{\text{Wolke}}$ eine geschätzte Geschwindigkeit des Wolkenzugs

bezeichnen.

12. Vorrichtung nach Anspruch 11, bei der die Vorrichtung eine photovoltaische Anlage ist.

13. System umfassend mindestens eine Vorrichtung nach einem der Ansprüche 11 oder 12.

**Claims**

1. Method for determining a power output by a photovoltaic installation

   - on the basis of at least one item of shading information from at least one adjacent photovoltaic installation,
   - wherein several items of shading information are provided by several adjacent photovoltaic installations,
   - wherein a temporal and spatial forecast in relation to an imminent shading is established on the basis of the shading information,
   - wherein the expected power output by the photovoltaic installation is determined on the basis of the imminent shading,
   - wherein a speed of a shading, in particular of a cloud drift, is established by maximizing a cross-correlation $R_{ab}$

$$R_{ab} = \frac{1}{T} \cdot \int\limits_{-T/2}^{T/2} P_a(t) \cdot P_b(t+\tau)\,dt \;,$$

   with

$$\tau = \frac{d_{ab}}{v_{\text{Cloud}}}\,,$$

   where

   a, b denote two photovoltaic installations,
   T denotes a considered time interval,
   P denotes a feed-in power,
   $d_{ab}$ denotes a distance between the photovoltaic installations a and b,
   $v_{\text{Cloud}}$ denotes an estimated speed of the cloud drift.

2. Method according to Claim 1, wherein the shading information comprises an item of information based on a reduced brightness and, in particular, based on a shading caused by cloud movement.

3. Method according to one of the preceding claims, wherein another energy source is activated depending on the expected power output by the photovoltaic installation.

4. Method according to Claim 3, wherein the other energy source comprises at least one of the following energy sources:

   - a controllable load,
   - an energy store,
   - an energy producer.

5. Method according to one of the preceding claims, wherein the several adjacent photovoltaic installations spatially surround the photovoltaic installation at least in part.

6. Method according to one of the preceding claims, wherein, on the basis of the shading information, a temporal and spatial forecast in relation to an imminent shading is established using a forecasting model.

7. Method according to one of the preceding claims, wherein a direction of the shading, in particular of the cloud drift, is established on the basis of a comparison of the cross-correlations of spatially differently aligned photovoltaic installations.

8. Method according to one of the preceding claims, wherein

   - a direction of an airflow is determined,
   - a variance of the cross-correlation of photovoltaic installations at different distances apart is determined;
   - a change in the shading, in particular a change in a shape of the cloud drift, is established on the basis of the direction of the airflow and the variance.

9. Method according to Claim 8, wherein the expected power output by the photovoltaic installation is determined on the basis of the established change in the shading.

10. Method according to Claim 9, wherein the photovoltaic installation power is determined on the basis of a hybrid model, in particular on the basis of an error correction neural network.

11. Device for setting a photovoltaic installation with a processing unit, which is configured such

   - that a power output by the photovoltaic installation can be determined on the basis of at least one item of shading information from at least one adjacent photovoltaic installation,
   - that several items of shading information are provided by several adjacent photovoltaic installations,
   - that a temporal and spatial forecast in relation to an imminent shading is established on the basis of the shading information,
   - that the expected power output by the photovoltaic installation is determined on the basis of the imminent shading,
   - that a speed of a shading, in particular of a cloud drift, is established by maximizing a cross-correlation $R_{ab}$

$$R_{ab} = \frac{1}{T} \cdot \int_{-T/2}^{T/2} P_a(t) \cdot P_b(t + \tau)\, dt \,,$$

with

$$\tau = \frac{d_{ab}}{v_{\text{Cloud}}} \,,$$

where

a, b denote two photovoltaic installations,
T denotes a considered time interval,
P denotes a feed-in power,
$d_{ab}$ denotes a distance between the photovoltaic installations a and b,
$v_{\text{Cloud}}$ denotes an estimated speed of the cloud drift.

**12.** Device according to Claim 11, wherein the device is a photovoltaic installation.

**13.** System comprising at least one device according to either of Claims 11 and 12.

## Revendications

**1.** Procédé de détermination d'une puissance fournie par une installation photovoltaïque

- sur base d'au moins une information d'ombrage d'au moins une installation photovoltaïque voisine,
- dans lequel plusieurs informations d'ombrage de plusieurs installations photovoltaïque voisines sont procurées,
- dans lequel, sur base des informations d'ombrage, une prédiction temporelle et locale se référant à un ombrage imminent est établie,
- dans lequel, à l'aide de l'ombrage imminent, la puissance fournie attendue de l'installation photovoltaïque est déterminée,
- dans lequel la vitesse d'un ombrage, en particulier d'une traînée de nuages est établie par la maximisation d'une corrélation transversale $R_{ab}$,

$$R_{ab} = \frac{1}{T} \cdot \int_{-T/2}^{T/2} P_a(t) \cdot P_b(t + \tau)\, dt$$

avec

$$\tau = \frac{d_{ab}}{v_{\text{Wolke}}} \,,$$

dans lesquelles

a, b désignent deux installations photovoltaïques,
T désigne un intervalle de temps considéré,
P désigne une puissance d'alimentation,
$d_{ab}$ désigne une distance entre les installations photovoltaïques a et b,
$v_{\text{Wolke}}$ désigne une vitesse estimée de la traînée de nuages.

**2.** Procédé selon la revendication 1, dans lequel les informations d'ombrage englobent une information relative à une diminution de la luminosité et en particulier se basant sur un ombrage dû à un mouvement des nuages.

**3.** Procédé selon l'une des revendications précédentes, dans lequel, en fonction de la puissance fournie attendue de l'installation photovoltaïque, une autre source d'énergie est activée.

**4.** Procédé selon la revendication 3, dans lequel l'autre source d'énergie comprend au moins l'une des sources d'énergie suivantes:

- un récepteur réglable,
- un réservoir d'énergie,
- un producteur d'énergie.

**5.** Procédé selon l'une des revendications précédentes, dans lequel la pluralité d'installations photovoltaïques voisines entoure spatialement au moins partiellement l'installation photovoltaïque.

**6.** Procédé selon l'une des revendications précédentes, dans lequel, sur base des informations d'ombrage, une prédiction temporelle et spatiale se référant à un ombrage imminent est établie à l'aide d'un modèle de prédiction.

**7.** Procédé selon l'une des revendications précédentes, dans lequel la direction de l'ombrage, en particulier de la traînée de nuages, est établie à l'aide d'une comparaison des corrélations transversales d'installations photovoltaïques orientées différemment dans l'espace.

**8.** Procédé selon l'une des revendications précédentes, dans lequel:

- la direction d'un courant d'air est déterminée,

- la variance de la corrélation transversale d'installations photovoltaïques très différemment éloignées est déterminée,

- à l'aide de la direction du courant d'air et de la variance, une modification de l'ombrage, en particulier une modification de la forme de la traînée de nuages, est déterminée.

**9.** Procédé selon la revendication 8, dans lequel la puissance fournie attendue de l'installation photovoltaïque est déterminée sur base de la modification établie de l'ombrage.

**10.** Procédé selon la revendication 9, dans lequel la puissance de l'installation photovoltaïque est déterminée sur base d'un modèle hybride, en particulier d'un réseau neuronal à correction d'erreurs.

**11.** Dispositif de réglage d'une installation photovoltaïque avec unité de traitement réglée de manière que:

- la puissance fournie par l'installation photovoltaïque peut être déterminée sur base d'au moins une information d'ombrage d'au moins une installation photovoltaïque voisine,

- une pluralité d'informations d'ombrage de plusieurs installations photovoltaïques voisines est procurée,

- sur base des informations d'ombrage, une prédiction temporelle et locale se référant à un ombrage imminent est établie,

- à l'aide de l'ombrage imminent, la puissance fournie attendue de l'installation photovoltaïque est déterminée,

- la vitesse d'un ombrage, en particulier d'une traînée de nuages, est établie par la maximisation d'une corrélation transversale $R_{ab}$,

$$R_{ab} = \frac{1}{T} \cdot \int_{-T/2}^{T/2} P_a(t) \cdot P_b(t+\tau)dt$$

avec

$$\tau = \frac{d_{ab}}{v_{\text{Wolke}}},$$

a, b désigne deux installations photovoltaïques,
T désigne un intervalle de temps considéré,
P désigne une puissance d'alimentation,
dab désigne une distance entre les installations photovoltaïques a et b,
$v_{\text{Wolke}}$ désigne une vitesse estimée de la traînée de nuages.

**12.** Dispositif selon la revendication 11, dans lequel le dispositif est une installation photovoltaïque.

**13.** Système comprenant au moins un dispositif selon l'une des revendications 11 ou 12.

Fig.1

Fig.2

201 → 202 → 203

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2010186840 A
- JP 2008182017 A
- JP 2007184354 A
- EP 2262096 A2
- US 20110084551 A1

**In der Beschreibung aufgeführte Nicht-Patentliteratur**

- Modeling of Dynamical Systems by Error Correction Neural Networks. **ZIMMERMANN H. G. ; NEUNEIER R. ; GROTHMANN R.** Modeling and Forecasting Financial Data, Techniques of Nonlinear Dynamics. Kluwer Academic Publishers, 2002, 237-263